## Europäisches Patentamt
## European Patent Office
## Office européen des brevets

(11) Veröffentlichungsnummer: **0 017 876**
**A1**

# EUROPÄISCHE PATENTANMELDUNG

(21) Anmeldenummer: **80101824.3**

(51) Int. Cl.³: **G 01 R 1/04**

(22) Anmeldetag: **03.04.80**

(30) Priorität: **11.04.79 DE 2914761**

(71) Anmelder: **SIEMENS AKTIENGESELLSCHAFT Berlin und München, Postfach 22 02 61, D-8000 München 22 (DE)**

(43) Veröffentlichungstag der Anmeldung: **29.10.80** **Patentblatt 80/22**

(84) Benannte Vertragsstaaten: **AT BE CH FR GB IT LI NL SE**

(72) Erfinder: **Koslar, Manfred, Dipl.-Ing., Schröderstrasse 16, D-4840 Rheda-Wiedenbrück (DE)**

(54) **Elektrisches Vielfachmessinstrument.**

(57) Das Gerät zum Messen von Gleich- oder Wechselspannungen sowie von Widerstandswerten besteht aus zwei miteinander verbundenen Griffen (1, 2), wobei in einem der Griffe (2) eine Spannungsquelle (3) samt Ladeeinrichtung (4) und in dem anderen Griff (1) die Bauelemente (28), Baugruppen (29), eine LCD-Ziffernanzeige (8) und zwei Schalter (9, 10) für die Funktionen und die Meßbereiche untergebracht sind. Die Schalter (9, 10) bestehen aus rollenden Wälzkontakten (14) und einer gemeinsamen, mit ihnen zusammenwirkenden Schalterkarte (13), auf der auch ein Meßteiler (34) untergebracht ist sowie aus einer Anzeigekarte (30), auf der die gesamte Elektronik untergebracht ist, wobei die Schalterkarte (13) und Anzeigekarte (30) höhenversetzt angeordnet sind.

BEZEICHNUNG GEÄNDERT
siehe Titelseite

SIEMENS AKTIENGESELLSCHAFT     Unser Zeichen

Berlin und München            VPA
                              79 P 8 0 1 6 EUR

Gerät zum Messen von Gleich- oder Wechselspannungen
sowie der Werte von elektrischen Widerständen

Die Erfindung betrifft ein Gerät zum Messen von Gleich-
oder Wechselspannungen sowie der Werte von elektrischen
Widerständen, bei dem der jeweils gemessene Wert durch
eine Flüssigkristallanzeige (LCD-Anzeige) digital dargestellt wird, das ferner eine Spannungsquelle und eine
Ladeeinrichtung für diese enthält und das in Form zweier durch ein Kabel verbundener, mit je einer Prüfspitze
versehener Griffe aufgebaut ist, wobei in einem der
Griffe die Spannungsquelle samt Ladeeinrichtung und in
dem anderen Griff die elektronischen Bauelemente und
Baugruppen, die Ziffernanzeige und zwei Schalter für die
Wahl der einzelnen Funktionen und die Wahl der Meßbereiche untergebracht sind.

In dem Prospekt "DIGI-CHECK", Digitalispräzisionsmultimeter, den die Firma Steinel erstmals auf der Ausstellung "Electronica 1978" in der Zeit vom 9. bis
15.11.1978 in München verteilt hat, ist ein solches, auf

Bck 1 Dx / 10.04.1979

die vorliegende Erfindung zurückgehendes Meßgerät, das selbst nur in einem Exemplar für Demonstrationszwecke vorlag und an Dritte nicht verteilt wurde, abgebildet und hinsichtlich der möglichen Funktionen erläutert.

Die beiden Griffteile sind wenig größer als bei normalen Spannungsprüfern üblich. Es handelt sich damit um ein Handinstrument, das zur Durchführung verschiedenster Meßaufgaben in der Elektronik und in der Elektrotechnik geeignet ist.

Die Aufgabe, die der vorliegenden Erfindung zugrunde lag, besteht darin, die konstruktive Gestaltung im Innern des Prüfgerätes in einer Weise auszuführen, die es erlaubt, ein Meßgerät in kompakter, handlicher Form zu erstellen; die für die Messung jeweils zu berührenden Prüfpunkte und die Meßwertanzeige sollen im gleichen Blickfeld der Prüfperson liegen, die Umschaltung auf die einzelnen Meßfunktionen und die Einstellung der einzelnen Meßbereiche der Meßfunktionen soll während des Meßvorganges erfolgen können und nicht zuletzt soll das Gerät nicht nur die Spannungsquelle für die Meßvorgänge, sondern auch eine Ladeeinrichtung für die Spannungsquelle enthalten. Bekannte Meßgeräte sind nicht geeignet, alle diese Forderungen gleichzeitig zu erfüllen, denn entweder sind diese Geräte nicht aus Griffen als Handinstrumente aufgebaut, sondern als Tischgerät, oder sie sind nur für eine Funktion, beispielsweise Spannungsmessung geeignet, oder aber die Umschaltung auf verschiedene Meßfunktionen und unterschiedliche Meßbereiche haben die Betätigung mit nur einer Hand wegen der verwendeten Funktions- und Bereichsschalter unmöglich gemacht.

Zur Lösung der Aufgabe ist das eingangs angegebene Gerät erfindungsgemäß gekennzeichnet durch folgende Merkmale:

a) beide Schalter bestehen aus einer gemeinsamen, mehrlagigen, gedruckte Leitungsbahnen und Kontaktflächen aufweisenden Schalterkarte und über die Kontaktflächen der Leitungsbahnen rollenden Wälzkontakten, die in je zwei Kontaktwalzengehäusen zusammengefaßt sind, für deren Bewegung die Schalterkarte einen Schlitz enthält und die mit einem rasternden Schieber verbunden sind, welcher in gleitschienenförmigen Bahnen in zwei der den Griff bildenden Gehäuseteilen geführt werden und die Rasterung des Schiebers mittels Mulden an der Innenseite der Gehäuseteile und in diese Mulden eingreifende, mit dem Schieber mitlaufende, federnde Rastarme erreicht wird;

b) die elektronischen Bauelemente, Baugruppen und die Ziffernanzeige sind auf einer Anzeigekarte angeordnet und durch gedruckte Leitungsbahnen ein- oder mehrlagig miteinander verschaltet, wobei zur Anwendung eines Zweischleifen-Integrationsverfahrens an sich bekannte, in Form von integrierten Bausteinen ausgeführte Baugruppen als Analog-Digital-Wandler, integrierter Vierfach-Operationsverstärker, Schaltnetzteile als DC/DC-Wandler und eine mit dem Analog-Digital-Wandler verbundene Flüssigkristall-Anzeige vorgesehen sind, die durch klemmenden Halt an der Anzeigekarte befestigt ist.

c) auf der Schaltkarte, die in Längsrichtung des Griffes an die Anzeigekarte anschließt und höhenversetzt mit ihr verbunden ist, ist ein schaltbarer Meßteiler vorgesehen, der aus Präzisionswiderständen und mit entsprechend zugeschalteten Kompensationskondensatoren für den Frequenzgang besteht und über die Verbindungsleitungen zwischen der Schalterkarte und der Anzeigekarte mit der dortigen Schaltung für die Vielfachfunktionen des Gerätes verbunden ist.

Das Merkmal a) ermöglicht einen besonders raumsparenden und flachen Schalter, weil die gemeinsame mehrlagige Schalterkarte von beiden Seiten ausgenutzt wird, weil durch die rollenden Wälzkontakte eine betriebssichere, abriebfreie und im Hinblick auf die Betätigung leichte und sicher handhabbare Funktion gewährleistet und weil mit einer gemeinsamen Schalterkarte zwei Schalter realisierbar sind, die mit Daumen und Zeigefinger einer Hand betätigt werden können.

Die Anordnung der elektronischen Bauelemente, Baugruppen und der Ziffernanzeige auf einer Anzeigekarte gemäß Merkmal b) stellt einerseits eine einfache übersichtliche und getrennt vorzunehmende Montage sicher und gewährleistet andererseits, daß Prüfungen der Funktionsfähigkeit vor der Endmontage des gesamten Gerätes möglich sind.

Die gegenseitige räumliche Anordnung der Schalterkarte und der Anzeigekarte gemäß Merkmal c) dient der Raumersparnis, weil alle elektronischen Bauelemente und Baugruppen auf einer Seite der Anzeigekarte angebracht werden können, so daß diese nur in einer Richtung Raum einnehmen, während die flache Ziffernanzeige auf der anderen Seite der Anzeigekarte untergebracht werden kann und damit in eine Ausnehmung der Griffhälfte hineingelegt und in dieser Weise von außen betrachtet werden kann. Die Anordnung des aus den Präzisionswiderständen und den Kompensationskondensatoren bestehenden Meßteils auf der Schalterkarte ermöglicht eine räumliche Trennung dieser für den Meßvorgang wesentlichen Bauelemente von den übrigen Bauelementen, so daß der über der Schalterkarte noch freie Raum sinnvoll ausgenutzt wird.

Vorzugsweise ist die LCD-Anzeige in einem Klemmbügel angeordnet, der mit mit Rastnasen versehenen Armen die Anzeigekarte klemmend umgreift, in dessen Mittelteil eine Fensteröffnung vorgesehen ist, an deren Längsseiten Vertiefungen zur Aufnahme von in Querrichtung elektrisch gut leitenden Gummistreifen für die Druckkontaktierung der Kontaktstellen der LCD-Anzeige mit den jeweiligen Kontaktflächen der Leiterbahnen der Anzeigekarte enthalten sind.

Die Erfindung wird nachfolgend an Hand der beigefügten Figuren näher erläutert.

Es zeigen:

Fig. 1 das aus den beiden Griffen bestehende Gerät in Draufsicht;

Fig. 2 den mit den Schaltern versehenen Griff, geöffnet;

Fig. 3 einen Schnitt gemäß Linie III-III in Fig. 2;

Fig. 4 den Klemmbügel zum Halt der Flüssigkristallanzeige.

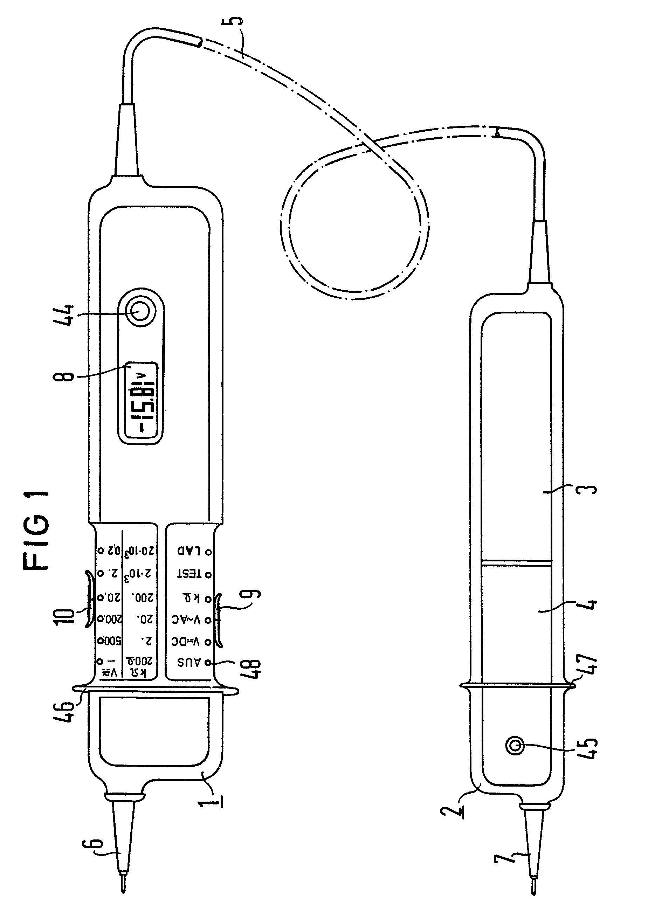

In Fig. 1 sind mit 1 und 2 die beiden Griffe des Meßgerätes gezeigt, die durch ein Kabel 5 miteinander verbunden sind. Im Griff 2 ist die Spannungsquelle 3, zum Beispiel vier Stück aufladbare Ni-Cd-Zellen, und die Ladeeinrichtung 4 untergebracht. Zum Aufladen der Spannungsquelle werden die Prüfspitzen 6 und 7 der Griffe 1 und 2 mit einer Stromquelle in Verbindung gebracht, so daß der
Ladevorgang ablaufen kann. Hierfür ist vorher der Funktionsschalter 9 auf die Funktion "Laden" einzustellen.
Der Ladevorgang wird durch die Leuchtdiode 45 angezeigt.

Der Griff 1 ist mit der Prüfspitze 6 versehen, die in
einer für solche Geräte üblichen Weise ausgestattet und
mit dem Griff 1 durch Verschraubung verbunden ist. Gleiches gilt für die Prüfspitze 7 im Hinblick auf den
Griff 2. Die Griffe 1 und 2 sind mit Abrutschrändern 46
und 47 versehen, die dazu dienen, ein Abrutschen der
Finger in Richtung auf eine Spannungsquelle zu vermeiden. Die Abrutschringe 46 und 47 dienen somit Sicherheitsgesichtspunkten.

Im Griff 1 sind der Funktionsschalter 9 und der Bereichsschalter 10 untergebracht; diese beiden Schalter
sind hier in Form ihrer von außen zu betätigender Griffe
dargestellt. Der Funktionsschalter 9 kann im vorliegenden Falle in sechs Funktionsstellungen gebracht werden,
wovon die dem Abrutschring 46 am nächsten liegende Funktionsstellung 48 dem Abschalten des Gerätes dient. Die
anderen Funktionsstellungen dienen der Reihe nach der
Gleichspannungsmessung (V-DC), der Wechselspannungsmessung (V-AC), der Widerstandsmessung (kΩ), dem Batterietest (Test) und dem Laden (Lad).

Der Bereichsschalter wird betätigt, um für die jeweiligen Funktionen den Meßbereich anzugeben, beispielsweise
bei Spannungsmessung 200 bis 500 V, 20 bis 199,9 V,
2,0 bis 19,99 V, 0,2 bis 1,999 V und 0,01 bis 1,99.9 mV.
Entsprechende Bereiche sind bei der Widerstandsmessung
vorgesehen, nämlich 0,1 bis 199,9 Ω, 0,2 bis 1,999 kΩ,
2,00 bis 19,999 kΩ, 20,0 bis 199,9 kΩ, 0,2 bis 1,999 MΩ
und 200 bis 19,99 MΩ.

Die Ziffernanzeige 8 ist als Flüssigkristallanzeige (LCD) ausgeführt und im Griff 1 so untergebracht, daß die Prüfperson beim Umfassen des Griffes 1 mit dem Daumen den Bereichsschalter 10 und mit dem Zeigefinger den Funktionsschalter 9 umschließt und damit die Anzeige 8 im Blickfeld hat. Wird die Messung örtlich an Stellen vorgenommen, an denen die Ziffernanzeige 8 für den Betrachter nicht im Blickfeld ist, so ist es möglich, durch Betätigung des Knopfschalters 44 den angezeigten Zahlenwert für einige Zeit zu speichern, so daß die Prüfperson den Griff 1 von der Meßstelle entfernen und den gemessenen Wert ablesen kann.

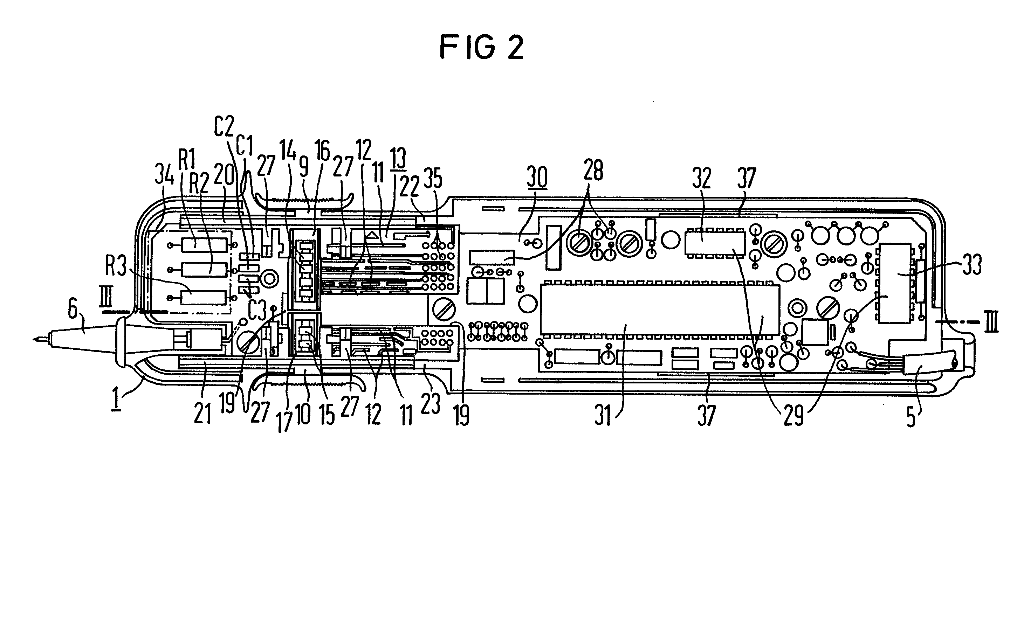

In Fig. 2, in der gleiche Teile wie in Fig. 1 mit gleichen Bezugsziffern versehen sind, ist der Griff 1 geöffnet gezeigt. Die Prüfspitze 6 ist durch Verschraubung mit dem Griff 1 verbunden.

Man erkennt in Fig. 2 zwei Platinen, nämlich die Schalterkarte 13 und die Anzeigekarte 30. Die Schalterkarte 13 ist mit gedruckten Leiterbahnen 11 und mit Kontaktierungsflächen 12 versehen, von denen hier nur einige angedeutet sind.

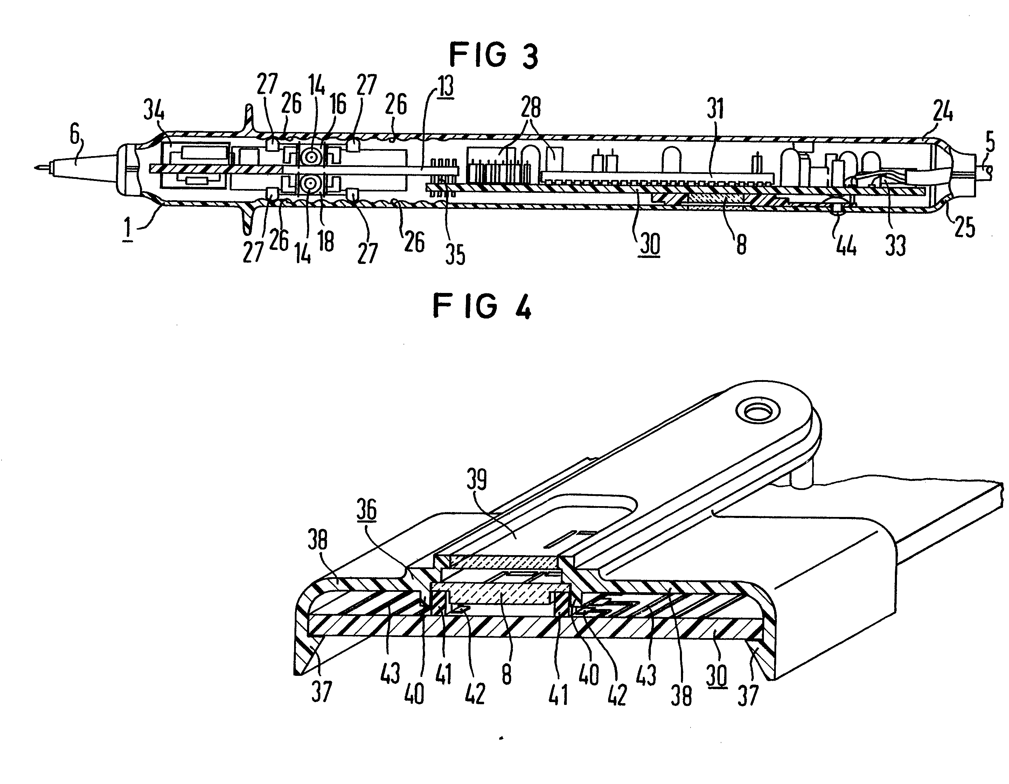

Jeder der beiden Schalter 9 und 10 ist an der gemeinsamen, mehrlagigen, gedruckte Leitungsbahnen 11 und Kontaktierungsflächen 12 tragende Schalterkarte 13 angebracht. Die rollenden Wälzkontakte 14 haben eine nachgiebige Oberfläche aus leitendem Material, beispielsweise ein mit Leitermaterial gefüllter Gummiring auf einem isolierenden Kunststoffrad oder ein rollender Metallring aus weichem Material. Auf diese Weise entsteht zwischen den Kontaktierungsflächen 12 über die Oberfläche der rollenden Wälzkontakte 14 ein flächenhafter Kontakt. Die rollenden Wälzkontakte 14 sind jeweils in Kontaktwalzengehäusen 16 und 17 zusammengefaßt. Da - wie aus Fig. 3 erkennbar - die Schaltkarte 13 von beiden Seiten betätigt wird, befinden sich auch auf der gegenüberliegenden Seite rollende Wälzkontakte 14, die ebenfalls in einem Kontaktwalzengehäuse 18 zusammengefaßt sind. Die Kontaktwalzengehäuse 16 und 17 sowie 18 (auch gegenüber dem Kontaktwalzengehäuse 17 befindet sich ein weiteres hier nicht gezeigtes Kontaktwalzengehäuse) sind durch Federdruck an die Schaltkarte 13 angepreßt. Für die Bewegung der Kontaktwalzengehäuse 16, 17, 18 an der Schaltkarte 13 weist diese einen Schlitz 19 auf, der sich über den gesamten Betätigungsbereich der beiden Schalter 9 und 10 erstreckt. Jeder Schalter 9 oder 10 ist für sich bedienbar. Die Kontaktwalzengehäuse 16, 17, 18 sind mit einem rasternden Schieber 20, 21 verbunden, welcher in gleitschienenförmigen Bahnen 22 und 23 in zwei der den Griff 1 bildenden Gehäuseteilen 24, 25 entlangläuft. Dies gewährleistet eine sichere Führung der Griffe und eine sichere Kontaktgabe der rollenden Wälzkontakte 14. Die Rasterung der Schieber 20, 21 wird dadurch bewirkt, daß mit den Schiebern 20, 21 mitlaufende federnde Rastarme 27 vorhanden sind, die in Mulden 26 im Innern der Gehäuseteile 24, 25 vorhanden sind. Die Rasterung entspricht jeweils einer vorgegebenen Einstellung der Schalter für den gewünschten Kontaktierungsvorgang.

Auf der in den Fig. 2 und 3 dargestellten Schalterkarte 30 sind die elektronischen Bauelemente 28, Baugruppen 29 und die Ziffernanzeige 8 angeordnet und durch gedruckte Leitungsbahnen ein- oder mehrlagig miteinander verschaltet. Für das bei diesem Meßgerät angewandte Zweischleifen-Integrationsverfahren sind an sich bekannte, in Form von integrierten Bausteinen ausgeführte Baugruppen 29 vorgesehen. Der Analog-Digital-Wandler 31 (AD-Wandler), der hier verwendet ist, arbeitet nach dem Zweischleifen-(Dual-Slope)-Verfahren und ist in neuester LSI-C-MOS-EIN-CHIP-Version ausgeführt und als solcher auf dem Markt erhältlich. Ein solcher AD-Wandler 31 gewährleistet hohe Alterungsbeständigkeit, hohe Zuverlässigkeit und automatische Nullpunktkorrektur. Der AD-Wandler 31 ist mit den übrigen passiven und/oder aktiven elektronischen Bauelementen 28 und ferner mit einem integrierten Vierfach-Operationsverstärker 32, mit Schaltnetzteilen als DC/DC-Wandler 33 und der LCD-Anzeige 8 in an sich üblicher Weise verschaltet.

Die im Handel befindliche LCD-Anzeige 8 ist (Fig. 4) in einem Klemmbügel 36 angeordnet. Die Arme 38 des Klemmbügels 36 sind mit Rastnasen 37 versehen und umgreifen damit die Anzeigekarte 30. Im Mittelteil des Klemmbügels 36 ist eine Fensteröffnung 39 vorgesehen. An den Längsseiten dieser Fensteröffnung 39 sind Vertiefungen 40 enthalten. Diese Vertiefungen 40 dienen zur Aufnahme von Gummistreifen 41, die in Querrichtung elektrisch gutleitende Sektionen aufweisen, während in Längsrichtung ein sehr hoher elektrischer Widerstand besteht. Auf diese Weise können die Kontaktstellen der LCD-Anzeige 8, die zur Ansteuerung der einzelnen Ziffernfelder vorhanden sind, mit den jeweiligen Kontaktflächen 42 der Leiterbahnen 43 der Anzeigekarte 30 kontaktiert werden, und zwar durch Druckkontakt, weil die Gummistreifen durch den klemmenden Halt des Klemmbügels 36 an der Anzeigekarte 30 unter Druck stehen. Die Gummistreifen 41 dienen nicht nur der elektrischen Kontaktierung zwischen Anzeigekarte 30 und LCD-Anzeige 8, sondern sie üben auch eine mechanische, puffernde Haltewirkung für die LCD-Anzeige 8 aus.

Eine derartige Ausgestaltung des Klemmbügels 36 gewährleistet nicht nur eine äußerst raumsparende Unterbringung der LCD-Anzeige 8 an der Anzeigekarte 30, sondern der Klemmbügel 36 dient gleichzeitig als Montagevorrichtung. Bei der Montage des Gerätes wird in das Fenster zunächst die LCD-Anzeige 8 eingelegt, dann werden die beiden lamellierten Kontakt-Gummistreifen 41 eingelegt, wobei sie in den Vertiefungen 40 seitlich durch das Fenster gehalten werden. In dieser Zusammenstellung kann dann die Anzeigekarte 30 auf diese Anordnung gedrückt werden. Durch seitliches Verschieben in Längsrichtung der Anzeigekarte 30 erfolgt die Justierung der LCD-Anzeige 8, so daß schließlich die gesamte Anordnung korrekt auf der Anzeigekarte 30 positioniert ist.

Die LCD-Anzeige 8 ist direkt gegenüber dem AD-Wandler 31 angeordnet, wodurch die etwa dreißig Leitungen, die von dem AD-Wandler 31 zu der LCD-Anzeige 8 verlaufen, unmittelbar und raumsparend untergebracht sind.

In dem Klemmbügel 8 ist ferner der Tastschalter 44 enthalten, so daß auch dieser stets zusammen mit der Montage der LCD-Anzeige 8 in einfacher Weise am Meßgerät befestigt werden kann.

Die Schalterkarte 13 schließt in Längsrichtung des Griffes 1 an die Anzeigekarte 30 an und ist höhenversetzt mit ihr verbunden. Der Verbindung dienen die Verbindungsleitungen 35, die hier als Metallstifte ausgeführt sind, so daß die Verlötung nicht nur den elektrischen Kontakt, sondern auch den mechanischen Zusammenhalt sicherstellt.

Es ist selbstverständlich, daß die beiden Gehäuseteile 24 und 25 des Griffes 1 im Innern so ausgestaltet sind, daß die höhenversetzte Lage der Schalterkarte 13 in bezug auf die Anzeigekarte 30 unterstützt wird.

Auf der Schalterkarte 13 ist ein schaltbarer Meßteiler 34 vorgesehen. Dieser besteht aus mehreren Präzisionswiderständen R1, R2, R3 usw., denen zur Korrektur des Frequenzganges Kompensations-Kondensatoren C1, C2, C3 usw. entsprechend zugeschaltet sind. Über die Verbindungsleitungen 35, die nicht nur die beiden Schalter 9 und 10 mit der Elektronik der Anzeigekarte 30 verbinden, ist auch der Meßteiler 34 in die Gesamtverschaltung miteinbezogen.

Es ist ein besonderer Vorteil der vorliegenden Erfindung, daß das Meßgerät durch die konstruktive Ausnutzung des Innenraumes drei Meßfunktionen (Gleichspannungsmessung, Wechselspannungsmessung und Widerstandsmessung) und zwei Zusatzfunktionen (Batterietest, Laden) und bei den Meßfunktionen sechs Meßbereiche aufweist, alles in einer Form mit besonders kleinen Abmessungen. Der Griff 1 hat (ohne Prüfspitze 6) eine Gehäuseabmessung von $185 . 44 . 17 \ mm^3$. Der Griff 2 hat (ohne Prüfspitze 7) Gehäuseabmessungen von $135 . 32 . 16 \ mm^3$.

Alle Bedienungsvorgänge für den Funktionsschalter 9 und den Bereichschalter 6 können mit den Fingern der den Griff 1 umfassenden Hand während des Meßvorganges vorgenommen werden, wobei die LCD-Anzeige 8 stets im Blickfeld bleibt.

Der Griff 1 enthält die Schalterkarte 13, die mittels Schrauben an dem unteren Gehäuseteil 25 des Griffes 1 direkt und selbstschneidend befestigt sind. Die mechanische Festigkeit erhält die gesamte Anordnung des Griffes durch das Festschrauben der Schalterkarte 13 und der Anzeigekarte 30 im Griff 1.

Dadurch, daß die Gehäuseteile 24 und 25 des Griffes 1 überlappende Ränder aufweisen, werden die bei einem Meßgerät erforderlichen Kriechstrecken gewährleistet. Die Ränder sind in an sich bekannter Weise so konstruiert, daß der gesamte Griff selbstschnappend zusammenhält, so daß damit eine relativ gute Abdichtung gegen Staub bei gleichzeitig ausreichend langen Kriechstrecken gewährleistet wird.

Die Gummirollen 14 der Schalter 9 und 10 und auch die Gummistreifen 41, die zum Halt der Flüssigkristallanzeige dienen, gewährleisten - neben der konstruktiven Gesamtkonzeption - auch eine hohe Stoßsicherheit des Gerätes, so daß es gegenüber mechanischen Schockbeanspruchungen sehr unempfindlich ist.

2 Patentansprüche
4 Figuren
1 Bezugszeichenliste

Patentansprüche

1. Gerät zum Messen von Gleich- oder Wechselspannungen sowie der Werte von elektrischen Widerständen, bei dem der jeweils gemessene Wert durch eine Flüssigkristall-anzeige (8) (LCD-Anzeige) digital dargestellt wird, das ferner eine Spannungsquelle (3) und eine Ladeeinrichtung (4) für diese enthält und das in Form zweier durch ein Kabel (5) verbundener, mit je einer Prüfspitze (6, 7) versehener Griffe (1, 2) aufgebaut ist, wobei in einem der Griffe (2) die Spannungsquelle (3) samt Ladeeinrichtung (4) und in dem anderen Griff (1) die elektronischen Bauelemente und Baugruppen, die Ziffernanzeige (8) und zwei Schalter (9, 10) für die Wahl der einzelnen Funktionen und die Wahl der Meßbereiche untergebracht sind, g e k e n n z e i c h n e t   d u r c h folgende Merkmale:

a) beide Schalter (9, 10) bestehen aus einer gemeinsamen, mehrlagigen, gedruckte Leitungsbahnen (11) und Kontaktflächen (12) aufweisenden Schalterkarte (13) und über die Kontaktflächen (12) der Leitungsbahnen rollenden Wälzkontakten (14), die in je zwei Kontaktwalzengehäusen (16, 17, 18) zusammengefaßt sind, für deren Bewegung die Schalterkarte (13) einen Schlitz (19) enthält und die mit einem rasternden Schieber (20, 21) verbunden sind, welcher in gleitschienenförmigen Bahnen (22, 23) in zwei der den Griff (1) bildenden Gehäuseteilen (24, 25) geführt werden und die Rasterung des Schiebers (20, 21) mittels Mulden (26) an der Innenseite der Gehäuseteile (24, 25) und in diese Mulden (26) eingreifende, mit dem Schieber (20, 21) mitlaufende, federnde Rastarme (27) erreicht wird,

b) die elektronischen Bauelemente (28), Baugruppen (29) und die Ziffernanzeige (8) sind auf einer Anzeigekarte (30) angeordnet und durch gedruckte Leitungsbahnen ein- oder mehrlagig miteinander verschaltet, wobei zur Anwendung eines Zweischleifen-Integrationsverfahrens an sich bekannte, in Form von integrierten Bausteinen ausgeführte Baugruppen (29) als Analog-Digital-Wandler (31), integrierter Vierfach-Operationsverstärker (32), Schaltnetzteile als DC/DC-Wandler (33) und eine mit dem Analog-Digital-Wandler (31) verbundene Flüssigkristall-Anzeige (8) vorgesehen sind, die durch klemmenden Halt an der Anzeigekarte (30) befestigt ist,

c) auf der Schalterkarte (13), die in Längsrichtung des Griffes (1) an die Anzeigekarte (30) anschließt und höhenversetzt mit ihr verbunden ist, ist ein schaltbarer Meßteiler (34) vorgesehen, der aus Präzisionswiderständen (R1, R2, R3) und mit entsprechend zugeschalteten Kompensationskondensatoren (C1, C2, C3) für den Frequenzgang besteht und über die Verbindungsleitungen (35) zwischen der Schalterkarte (13) und der Anzeigekarte (30) mit der dortigen Schaltung für die Vielfachfunktionen des Gerätes verbunden ist.

2. Gerät nach Anspruch 1, d a d u r c h  g e - k e n n z e i c h n e t , daß die LCD-Anzeige (8) in einem Klemmbügel (36) angeordnet ist, der mit mit Rastnasen (37) versehenen Armen (38) die Anzeigekarte (30) klemmend umgreift, in dessen Mittelteil eine Fensteröffnung (39) vorgesehen ist, an deren Längsseiten Vertiefungen (40) zur Aufnahme von in Querrichtung elektrisch gutleitenden Gummistreifen (41) für die Druckkontaktierung der Kontaktstellen der LCD-Anzeige (8) mit den jeweiligen Kontaktflächen (42) der Leiterbahnen (43) der Anzeigekarte (30) enthalten sind.

0017876

## Bezugszeichenliste

1 Griff, der unter anderem die LCD-Anzeige und die
Schalter enthält,

2 Griff, der die Spannungsquelle und die Ladeeinrichtung enthält

3 Spannungsquelle

4 Ladeeinrichtung

5 Kabel zwischen Griff 1 und Griff 2

6 Prüfspitze am Griff 1

7 Prüfspitze am Griff 2

8 Flüssigkristallanzeige (LCD)

9 Schalter für die Wahl der    ⎫  angedeutet durch
Funktionen des Gerätes        ⎬  die Griffe der
10 Schalter für die Wahl          Schieber 20 und
der Meßbereiche               ⎭  21

11 Gedruckte Leitungsbahnen

12 Kontaktflächen

13 Schalterkarte

14 rollende Wälzkontakte des Schalters 9

15 rollende Walzkontakte des Schalters 10

16 Kontaktwalzengehäuse des Schalters 9

17 Kontaktwalzengehäuse des Schalters 10

18 Kontaktwalzengehäuse des Schalters 9
(als Gegenstück zu 16)

19 Schlitz in der Schaltkarte 13

20 rastender Schieber des Schalters 9

21 rastender Schieber des Schalters 10

22 gleitschienenförmige Bahnen für den Schieber 20

23 gleitschienenförmige Bahnen für den Schieber 21

24 oberes Gehäuseteil des Griffes 1

25 unteres Gehäuseteil des Griffes 1

0017876

26  Mulden an den Innenseiten der Gehäuseteile 24, 25

27  federnde Rastarme an den Schiebern 20, 21

28  elektronische Bauelemente

29  elektronische Baugruppen

30  Anzeigekarte, ein- oder mehrlagig mit gedruckten Leitungsbahnen versehen

31  Analog-Digital-Wandler (A/D-Wandler)

32  integrierter Vierfach-Operationsverstärker (Bi-FET-OP)

33  Schaltnetzteile als DC/DC-Wandler

34  schaltbarer Meßteiler mit den Präzisionswiderständen R1, R2, R3 und den Kompensationskondensatoren C1, C2, C3

35  Verbindungsleitungen zwischen Schalterkarte 13 und Anzeigekarte 30

36  Klemmbügel

37  Rastnasen

38  Arme des Klemmbügels 36

39  Fensteröffnung

40  Vertiefungen an den Längsseiten der Fensteröffnung 39

41  in Querrichtung und gutleitende Gummistreifen

42  Kontaktflächen auf der Anzeigekarte 30

43  Leiterbahnen auf der Anzeigekarte 30

44  Knopfschalter

45  Leuchtdiode im Griff 2

46  Abrutschrand am Griff 1

47  Abrutschrand am Griff 2

48  Funktionsstellung "Aus" des Funktionsschalters 9

FIG 1

# FIG 2

2/3

0017876

0017876

FIG 3

FIG 4

Europäisches
Patentamt

**EUROPÄISCHER RECHERCHENBERICHT**

0017876

Nummer der Anmeldung

EP 80101824.3

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| A | <u>DE - B - 1 248 795</u> (GRÜNDIG) <br> + Fig. 1 + <br> -- | 1 |
| P | <u>GB - A - 2 005 037</u> (SIEMENS) <br> (11-04-1980) <br> + Fig. 2 + <br> -- | 2 |
| A | <u>US - A - 3 609 545</u> (ENGELHARD) <br> + Fig. 4 + <br> -- | 1 |
| A | <u>US - A - 3 757 218</u> (OLIVIERO) <br> + Fig. 3 + <br> ---- | 1 |

**KLASSIFIKATION DER ANMELDUNG (Int.Cl. 3)**

G 01 R 1/04

**RECHERCHIERTE SACHGEBIETE (Int. Cl. 3)**

G 01 R 1/00

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 27-06-1980 | BERGER |

EPA form 1503.1  06.78